Europäisches Patentamt

European Patent Office

Office européen des brevets

(11) Publication number: **0 306 039**
**A2**

## EUROPEAN PATENT APPLICATION

(21) Application number: **88114351.5**

(51) Int. Cl.⁴: **H01L 29/08**

(22) Date of filing: **02.09.88**

(30) Priority: **03.09.87 JP 219136/87**

(43) Date of publication of application:
**08.03.89 Bulletin 89/10**

(84) Designated Contracting States:
**DE FR GB**

(71) Applicant: **Kabushiki Kaisha Toshiba
72, Horikawa-cho Saiwai-ku
Kawasaki-shi(JP)**

(72) Inventor: **Imamura, Souichi c/o Patent
Division
Kabushiki Kaisha Toshiba 1-1 Shibaura
1-chome
Minato-ku Tokyo 105(JP)**
Inventor: **Kakumoto, Munenari c/o Patent
Division
Kabushiki Kaisha Toshiba 1-1 Shibaura
1-chome
Minato-ku Tokyo 105(JP)**

(74) Representative: **Lehn, Werner, Dipl.-Ing. et al
Hoffmann, Eitle & Partner Patentanwälte
Arabellastrasse 4
D-8000 München 81(DE)**

(54) **Semiconductor device.**

(57) In a GaAs semiconductor device, a portion of the drain region (22b) just under the drain electrode (25b) is shallower than the portion of the source region (22a) just under the source electrode (25a). With this improvement, the leak drain current creeping into the substrate is reduced while satisfactorily suppressing the short channel effect, which is inevitable in the prior art FET.

# FIG. 4

## Semiconductor device

The present invention relates to a semiconductor device of compound semiconductor type and a method of manufacturing the same, and more particularly to a GaAs metal semiconductor field effect transistor (MES FET) of the type which operates in super-high frequencies and at low noise, and a method of manufacturing the same.

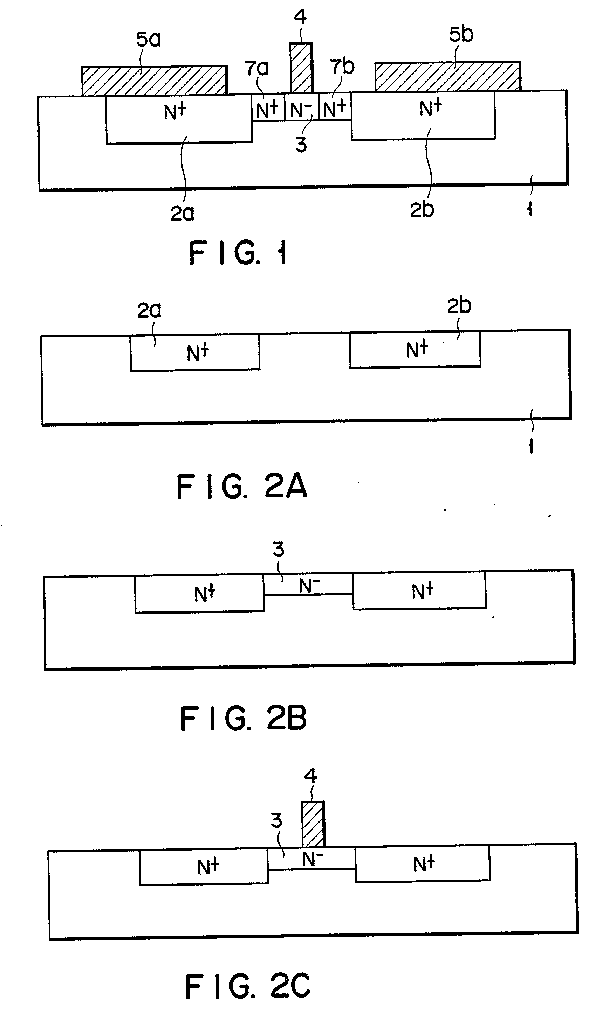

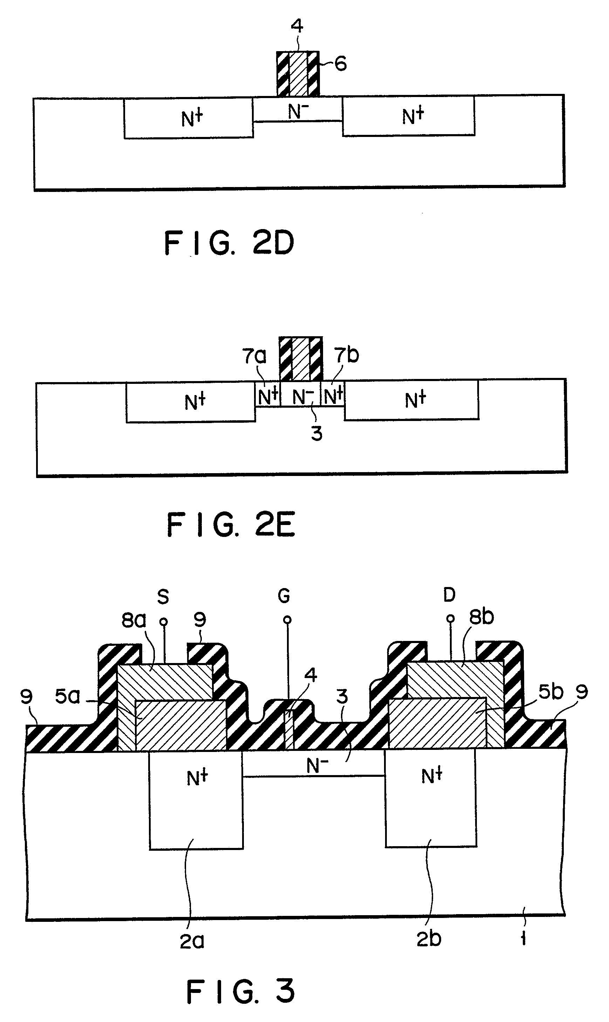

For a closer look at the structure of the GaAs MES GET, how the MES FET is manufactured will first be discussed. A typical structure of a conventional GaAs MES FET is in sectional form illustrated in Fig. 1. Figs. 2A through 2E show a sequence of process steps to manufacture the GaAs MES FET.

To start, first $N^+$ source region 2a and first $N^+$ drain region 2b are formed in the surface region of GaAs semiconductor substrate 1, by ion implantating process, for example, as shown Fig. 2A. These drain and source regions are heavily doped with an impurity. $N^-$ channel layer or an operating layer 3 is then formed in the surface region of the substrate by the same process, for example, as shown in Fig. 2B. Further, gate electrode 4 made of high-melting-point metal is formed on the gate layer by a lift-off technique or a dry-etching technique. Subsequently, silicon oxide $SiO_2$ is deposited on the entire surface of the structure by a CVD technique. The silicon oxide film is selectively stripped from the structure, while the film is left around the side wall of gate electrode 4. Second $N^+$ source region 7a and second $N^+$ region 7b, both being at a low resistance, are formed in the surface region of substrate 1, as shown in Fig. 1E, by a self-align technique based on the ion implantation. Finally, source electrode 5a and drain electrode 5b are formed as shown in Fig. 1, by lift-off process, to complete a called self-align MES FET also as shown in Fig. 1.

Another example of the prior art GaAs MES FET is shown in Fig. 3. A manufacturing process of this MES FET will first be described in brief referring to the figure. $N^+$ source region 2a and $N^+$ drain region 2b, both being heavily doped with an impurity, are formed in the surface region of GaAs semiconductor substrate 1, by ion implantation process, for example. $N^-$ channel layer 3 lightly doped with an impurity is formed in the substrate, as shown, by the same process, for example. Those drain, source and channel regions are thermally processed for activation. Subsequently, gate electrode 4, source electrode 5a, and drain electrode 5b are formed on the structure. Finally, pad electrodes 8a and 8b, and passivation film 9 are formed as shown.

In the MES FET thus structured, if the gate length of 1 $\mu m$ or less is used, viz., the submicron gate is used, the drain current ID is not saturated, particularly, in the high gate voltage region, or in a low drain current region. This fact implies reduction of the mutual conductance gm of the FET.

In the high frequency/low noise GaAs MES FETs, reduction of the gate length can most effectively improve the high frequency characteristics. In this field, the gate length reduction therefore is a common practice for those characteristic improvement. If the gate length is below 1 $\mu m$, however, the above unsaturation phenomenon becomes more distinguished. The result is of course reduction of mutual conductance gm, and degradation of noise figure (NF) and gain.

In the MES FET with reduced gate length. even if drain voltage VD is increased, drain current ID does not saturate in the low current region of the ID - VD curve. In the low ID current region, the increased drain voltage VD increases the current leaking into the GaAs substrate right under the channel. This current is frequently called a leak current. The unsaturation phenomenon is called a short channel effect. The cause for this phenomenon as has been described by many papers is that high gate voltage and high drain voltage create a high potential region in the channel layer closer to the drain region. Some measures to suppress the short channel effect exist. The first measure is to widen the space between the source and drain regions. The second measure is to more shallow these regions. These measures bring about increase of the source resistance and contact resistance. The result is also degradation of the FET characteristics including those in high frequencies.

Accordingly, an object of this invention is to provide a semiconductor device of compound semiconductor type which satisfactorily suppresses the short channel effect without any increase of the source resistance and the contact resistance.

According to one aspect of this invention, there is provided a semiconductor device of compound semiconductor type, improved in that a portion of the drain region just under the drain electrode being shallower than a portion of the source region just under the source electrode.

With this improvement, the leak drain current creeping into the substrate is reduced while satisfactorily suppressing the short channel effect, which is inevitable in the prior FET. The shallowed drain region has an increased drain resistance. However, the increase of the drain resistance has little adverse effect on the FET's high frequency characteristics including NF, gain and the like. The deep source region little contributes to the suppression of the short channel effect. The reason for this is that the leak current due to the short channel effect occurs in the region of the substrate, which is located right under the channel layer and closer to the drain region. This allows the deep source region to be used. The deep source region provides a low source resistance and hence a high mutual conductance gm.

According to another aspect of this invention, there is provided a method of manufacturing a semiconductor device of compound semiconductor type characterized in that a portion of the drain region just under the drain electrode is shallower than a portion of the source region just under the source electrode, comprising the steps of: implanting impurity ions into the different portions of said semiconductor substrate separately where source and drain regions are respectively to be formed and is located just under said source and drain electrodes, an ion implanting energy for forming the drain region being smaller than that for forming the source region.

According to yet another aspect of this invention, there is provided a method of manufacturing a semiconductor device of compound semiconductor type characterized in that a portion of the drain region just under the drain electrode is shallower than a portion of the source region just under the source electrode, comprising the step of: implanting impurity ions into the different portions of the semiconductor substrate simultaneously where source and drain regions are respectively to be formed and is located just under the source and drain electrodes, an ion implantation into the drain formed portion being performed through an implanted ion absorption film.

This invention can be more fully understood from the following detailed description when taken in conjunction with the accompanying drawings, in which:

Fig. 1 shows a sectional view illustrating a structure of a GaAs MES FET of a prior art:

Figs. 2A through 2E show sectional views showing a sequence of process steps for fabricating the prior art MES FET of Fig. 1;

Fig. 3 shows a sectional view illustrating a structure of a GaAs MES FET of another prior art;

Fig. 4 shows a sectional view illustrating a structure of a GaAs MES FET according to a first embodiment of this invention;

Fig. 5 shows a sectional view illustrating a structure of a GaAs MES FET according to a second embodiment of this invention;

Figs. 6A to 6C show sectional views of three types of the MES FETs for illustrating how the leak current flows due to the short channel effect, the structure of Fig. 6A showing that of the prior art and the structures of Figs. 6B and 6C showing those of the FETs according to this invention;

Figs. 7A through 7E show sectional views showing a sequence of process steps for fabricating the prior art MES FET of Fig. 4;

Figs. 8A through 8D show sectional views showing a sequence of process steps for fabricating the prior art MES FET of Fig. 5;

Figs. 9 and 11 show sectional views of modifications of the Fig. 4 embodiment; and

Figs. 10 and 12 show sectional views of modifications of the Fig. 5 embodiment.

Preferred embodiments of a semiconductor device of compound semiconductor type according to this invention will be described referring to the accompanying drawings.

Before proceeding with the present invention, it will distinctively be understood that N channel MES FETs will be discussed in detail, but the same description may correspondingly be applied to P channel MES FETs with P channel in place of N channel, and further that in the self-align type FET in which heavily doped $N^+$ region is formed with respect to the gate electrode in a self-align manner, this $N^+$ region includes the drain and source regions.

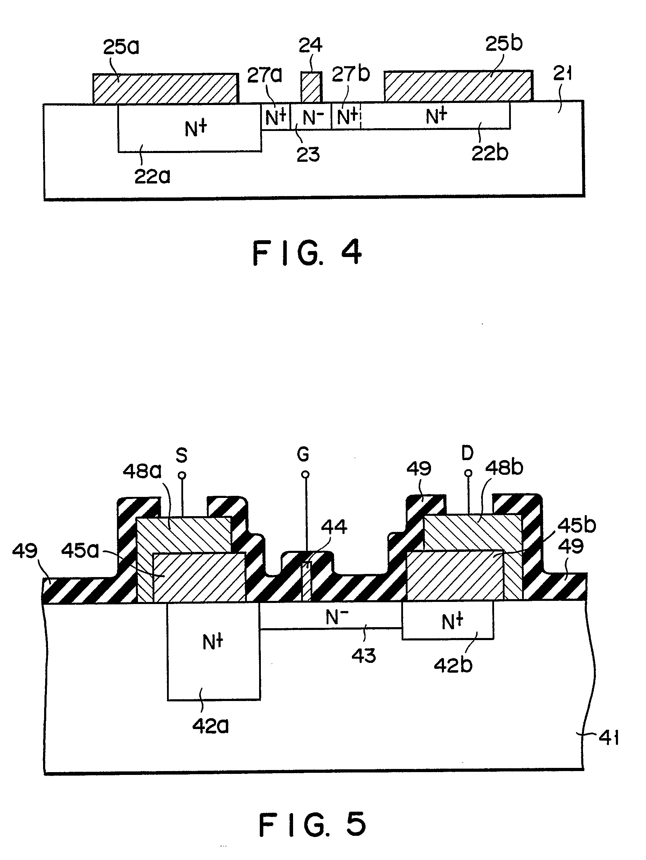

Reference is first made to Fig. 4 illustrating a first embodiment of a semiconductor device of compound semiconductor type. The semiconductor device illustrated in sectional form is a self-align MES field effect transistor. This transistor is fabricated on a GaAs semiconductor substrate 21 into which heavily impurity doped source and drain regions are formed. $N^-$ channel layer 23 is also formed in the surface region of substrate 21, while being located between and linked with the source and drain regions. The source region comprises first and second $N^+$ source regions 22a and 27a. These regions 22a and 27a are formed by separate process steps, and are stepped in thickness, as shown. Actually, the drain region is formed in the same process step as second source region 27a, and has the same thick as the second source region. For ease of comparison with the prior art structure, in this instance, it is assumed that the drain region also comprises first and second $N^+$ drain regions 22b and 27b. Gate electrode 24 is formed on channel region 23 in the substrate. The gate electrode made of high-melting-point metal cooperates with channel region 23, to form a Schottky barrier in the junction between them. Source and drain electrodes 25a and 25b are respectively formed on source and drain regions 22a and 22b. The electrode and region pairs are each in ohmic contact with each other. In the MES FET thus structured, it is noted that $N^+$ drain region 22b just under drain electrode 25b is shallower than $N^+$

source region 22a just under source electrode 25a.

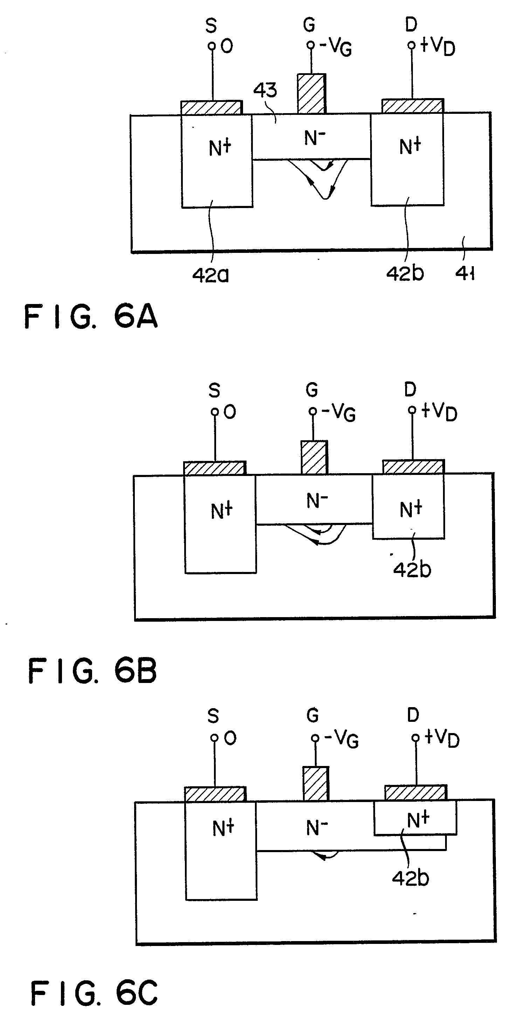

Turning now to Fig. 5, there is shown a second embodiment of a semiconductor device of compound type according to a second embodiment of this invention. The semiconductor device is expressed as a self-align MES FET also in this instance. Source and drain regions 42a and 42b, and channel region 43 disposed between them are diffused into the surface region of GaAs semiconductor substrate 41. Source and drain electrodes 25a and 25b are formed on source and drain regions 22a and 22b, respectively. Gate electrode 44 is formed on gate region 43. Source and drain pads 48a and 48b almost cover source and drain electrodes 45a and 45b, respectively. Passivation film 49 entirely covers the structure, with holes through which source and drain terminals S and D are led out to exterior.

The ID - VD characteristic of the FETs thus fabricated was measured. Good saturation was observed in the low drain current region of the tested FETs. Increased mutual conductance gm and good noise figure (NF) were also confirmed.

To satisfy the high frequency characteristics of high frequency GaAs FET, such as NF and gain, it is generally necessary to select the gate length to be 1 $\mu$m or less. If such figure is selected, the leak current leaking into the GaAs substrate under the channel layer increases, so that the short channel effect becomes more intensive. The short channel effect may be suppressed by shallowing the $N^+$ regions of source and drain. This measure, however, increases the source and drain resistance, resulting in degradation of the high frequency characteristics of the fabricated FET.

Generally, increase of the drain resistance more adversely influences the high frequency characteristics of the MES FETs than increase of the source resistance. The present invention follows the fact. In the present invention, the drain region is shallowed, while the source region is intact in thick, with an intention to suppress the short channel effect and to keep the source resistance low.

Three examples of GaAs FETs are illustrated in sectional form in Figs. 6A to 6C. The FET shown in Fig. 6A is a prior art FET where the source and drain regions are both deep. The FETs shown in Figs. 6B and 6C are those according to this invention where the drain region is shallower than the source region. The FETs are placed under voltages in the following. The source electrode is at ground potential. A positive voltage +VD is applied to the drain electrode D. A negative voltage -VG is applied to the gate electrode G. Generally, the current flowing from $N^+$ drain region 42b to $N^+$ source region distributes according to a distribution of the resultant effective resistance. In other words, the current are distributed into the paths of lower resultant effective resistance. The pinch-off occurs at the channel layer 43 closer to the drain region 42b. The effective conductivity of the pinch-off occurring portion of the channel layer is very small and approximate to that of the semiconductor substrate in contact with that portion. Part of the current ID would flow through the substrate. This phenomenon is well illustrated in Figs. 6A to 6C. In the figures, thin lines with arrows IL indicate the flow of the ID current. As shown, in the case of the Fig. 6A FET having thick source and drain regions, the drain current ID would greatly leak into the substrate. In the case of the Figs. 6B and 6C having the shallow drain region, the leak current IL would be small. In all of those case, the large leak current is observed just under the channel region closer to the drain region. The depth of the source region little contributes to the leak current phenomenon. The phenomenon depends largely on the depth of the drain region.

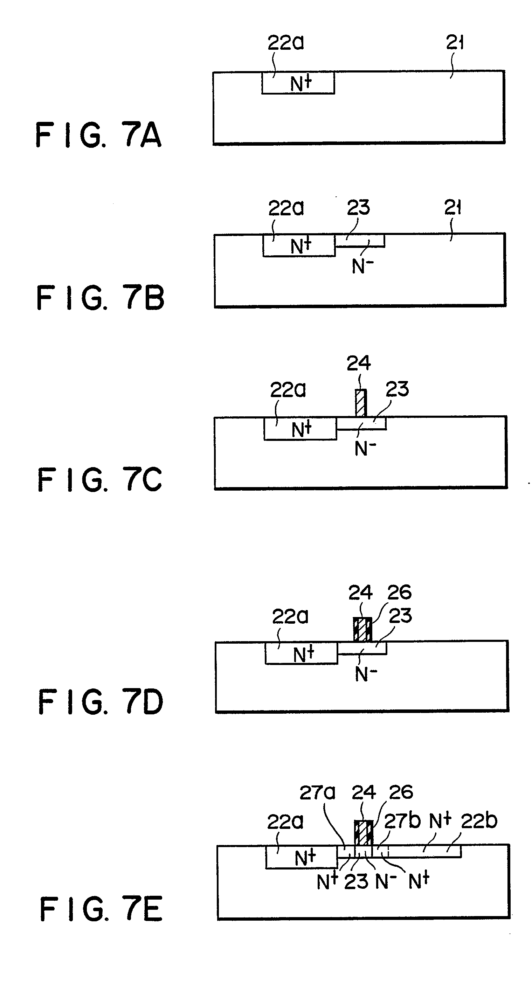

A method of fabricating the GaAs MES FET of Fig. 4, which is the first embodiment of this invention, will be described referring to Figs. 7A through 7E. To start, silicon Si ions are doped into a predetermined portion of GaAs semiconductor substrate 21 at acceleration voltage of 250keV and dosage of 5 x $10^{13}$cm$^{-2}$, to form first $N^+$ source region 22a. See Fig. 7A. Then, silicon Si ions are doped into another predetermined portion of GaAs semiconductor substrate 21 at acceleration voltage of 80keV and dosage of 2 x $10^{12}$cm$^{-2}$, to form $N^-$ channel layer 23. See Fig. 7B. Subsequently, gate electrode 24 made of high-melting-point metal is formed on channel layer 23 by known lift-off process and dry etching process. See Fig. 7C. Silicon oxide SiO$_2$ film is deposited on the entire surface of the structure by CVD process. See Fig. 7D. Then, dry etching process is applied to form side wall 26 on the side walls of gate electrode 24. See Fig. 7D. Following this step, first $N^+$ drain region 22b, second $N^+$ drain region 27b of low resistance, and second $N^+$ source region 27a are formed in the surface region of the substrate, by implanting Si ions at acceleration voltage of 80keV and dosage of 5 x $10^{13}$cm$^{-2}$ by the self-align technique. See Fig. 7E. Finally, source and drain electrodes 25a and 25b are formed by lift-off process, to complete the self-align MES FET as shown in Fig. 4.

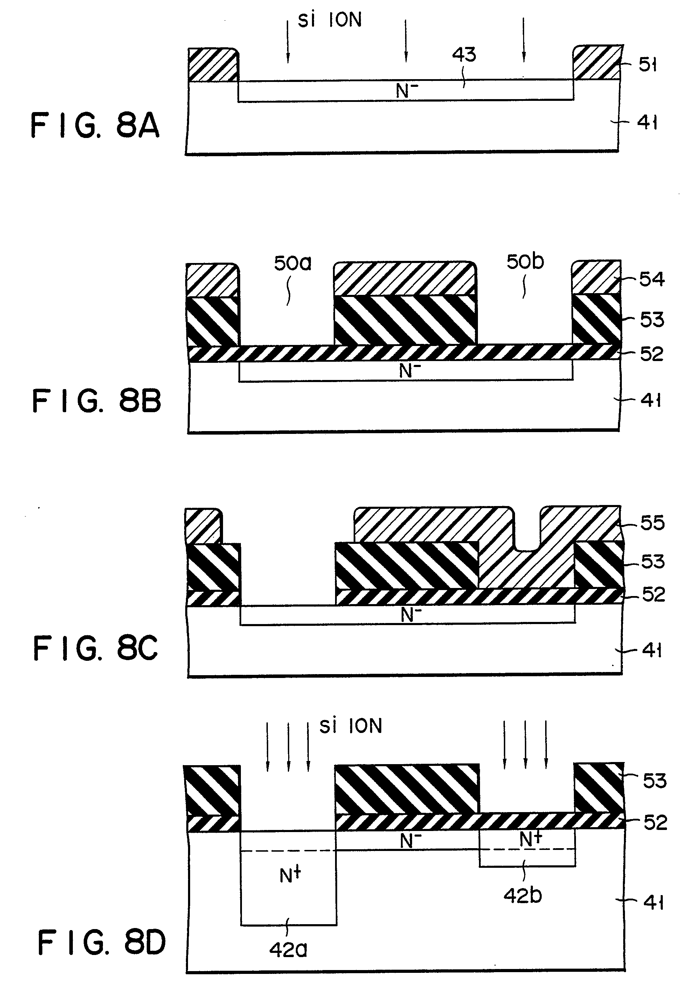

A method of fabricating the GaAs MES FET of Fig. 5, which is the second embodiment of this invention, will be described referring to Figs. 8A through 8E. To start, resist pattern 51 is formed on GaAs substrate 41, and silicon Si ions are doped into a predetermined portion of GaAs semiconductor substrate 41 at acceleration voltage of 80keV and dosage of 2 x $10^{12}$cm$^{-2}$, to form $N^-$ layer 43. See Fig. 8A.

Then, SiO₂ is grown on the substrate 41, to form SiO₂ film 52, approximately 1000 Å thick. Then, siN is further deposited on the formed SiO₂ film, to form another SiO₂ film 53, 10000 Å thick. Resist pattern 54 is formed on the SiN film 53. Dry etching process is applied to the resist film 54, and selectively etches the film to form holes 50a and 50b just under which N⁺ source region and N⁺ drain region are to be formed. See Fig. 8B.

Only opening 52b for the drain is covered with resist layer 55. Only the SiO₂ layer for the source is removed by wet etching process. See Fig. 8C. After removal of resist film 55, silicon Si ions are doped into the substrate through holes 50a and 50b, at acceleration voltage of 200keV and dosage of $5 \times 10^{13} cm^{-2}$. As a result, N⁺ source and drain regions 42a and 42b are simultaneously formed. See Fig. 8D. Since the ion implantation to drain region 42b is performed through SiO₂ film 52 capable of absorbing the implanted energy, the resultant drain region is shallower than the source region.

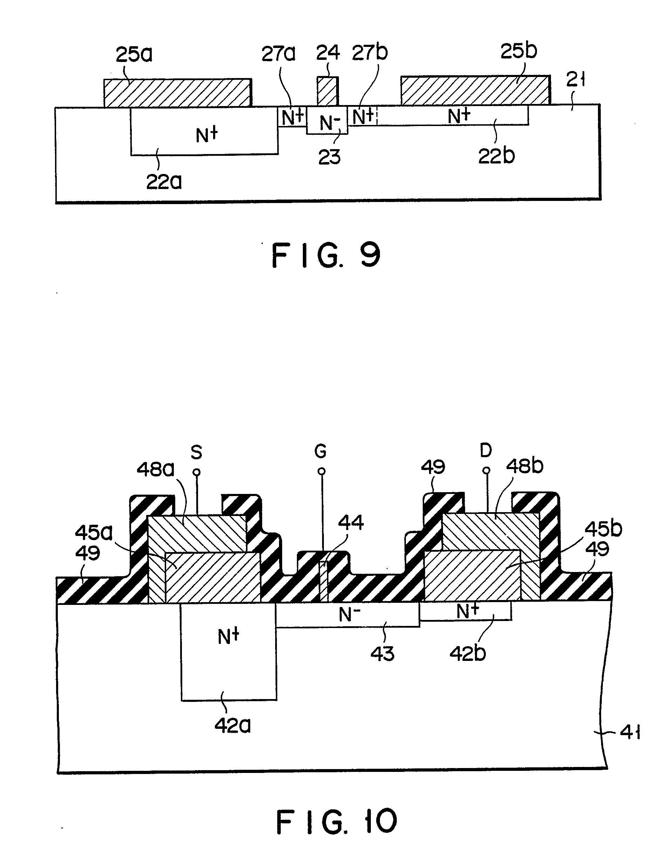

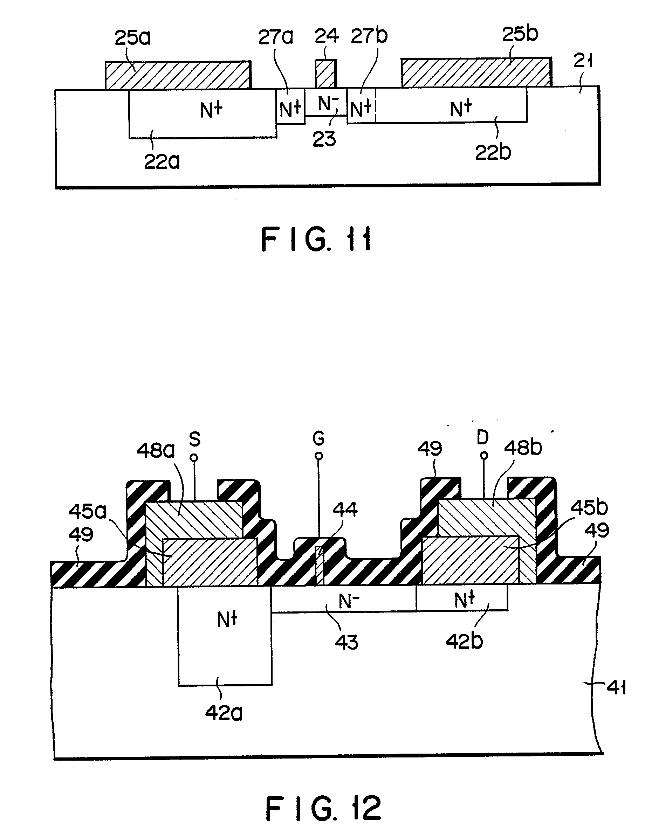

Several examples of modifications of the embodiments as mentioned are illustrated in Figs. 9 to 12. As shown, the N⁺ drain region may be equal to, shallower or deeper than the N⁻ channel layer, so long as the drain region is shallower than the source region. Figs. 9 and 11 show modifications of the Fig. 4 embodiment. In Fig. 9, drain region 22b including second source region 27a is shallower than channel layer 23. In Fig. 11, to the contrast, the former is deeper than the latter. Figs. 10 and 12 show modifications of the Fig. 5 embodiment. In Fig. 10, channel layer 43 is deeper than drain region 42b. In Fig. 12, channel region 43 is equal to drain region 42b.

As seen from the foregoing description, in fabricating the GaAs MES FET, the drain region is shallower than the source region. This structural feature allows the channel length to be within 1 $\mu$m, while satisfactorily suppressing the short channel effect. Therefore, the drain current saturation may be secured in the low drain current. Consequently, the FET's characteristics including mutual conductance gm, NF, gain, and the like may be remarkably improved.

## Claims

1. A semiconductor device of compound semiconductor type comprising:
a channel layer (23, 43), and heavily impurity doped source and drain regions (22a, 42a, and 22b, 42b) formed in the surface region of a semiconductor substrate (21, 41), said channel being located between said source and drain regions, and said channel layer, and said source and drain regions being of a first conductivity type: and

a gate electrode (24, 44), and source and drain electrodes (25a, 45a and 25b, 45b) formed on said semiconductor substrate (21, 41), said gate electrode cooperating with said channel layer (23, 43) to form a Schottky barrier, and said source and drain electrodes being in ohmic contact with said source and drain regions,

characterized in that:

a portion of said drain region just under said drain electrode is shallower than a portion of said source region just under said source electrode.

2. A method of manufacturing a semiconductor device of compound semiconductor type having a channel layer (23, 43), and heavily impurity doped source and drain regions (22a, 42a, and 22b, 42b) formed in the surface region of a semiconductor substrate (21, 41), said channel being located between said source and drain regions, and said channel layer, and said source and drain regions being of a first conductivity type, a gate electrode (24, 44), and source and drain electrodes (25a, 45a and 25b, 45b) formed on said semiconductor substrate (21, 41), said gate electrode cooperating with said channel layer (23, 43) to form a Schottky barrier, and said source and drain electrodes being in ohmic contact with said source and drain regions, and a portion of said drain region just under said drain electrode being shallower than a portion of said source region just under said source electrode, said method characterized by comprising the steps of:

implanting impurity ions into the different portions of said semiconductor substrate separately where source and drain regions are respectively to be formed and is located just under said source and drain electrodes, an ion implanting energy for forming said drain region being smaller than that for forming said source region.

3. A method of manufacturing a semiconductor device of compound semiconductor type having a channel layer (23, 43), and heavily impurity doped source and drain regions (22a, 42a, and 22b, 42b) formed in the surface region of a semiconductor substrate (21, 41), said channel being located between said source and drain regions, and said channel layer, and said source and drain regions being of a first conductivity type, a gate electrode (24, 44), and source and drain electrodes (25a, 45a and 25b, 45b) formed on said semiconductor substrate (21, 41), said gate electrode cooperating with said channel layer (23, 43) to form a Schottky barrier, and said source and drain electrodes being in ohmic contact with said source and drain regions, and a portion of said drain region just under said drain electrode being shallower than a portion of said source region just under said source electrode, said method characterized by comprising the steps of:

implanting impurity ions into the different portions of said semiconductor substrate simultaneously where source and drain regions are respectively to be formed and is located just under said source and drain electrodes, an ion implantation into said drain formed portion being performed through an implanted ion absorption film (52).

4. The semiconductor device according to claim 1, characterized in that said source region includes a first region (22a) being in contact with said source electrode (25a, 4a) and deeper than said drain region (22b. 42b), and a second region (27a) being in contact with said channel layer (23) and shallower than said first region.

5. The semiconductor device according to claim 1, characterized in that said drain region (22b, 42b) is deeper than said channel layer (23).

6. The semiconductor device according to claim 1, characterized in that said drain region (22b, 42b) is equal to said channel layer (23).

7. The semiconductor device according to claim 1, characterized in that said drain region (22b, 42b) is shallower than said channel layer (23).

F I G. 1

F I G. 2A

F I G. 2B

F I G. 2C

F I G. 2D

F I G. 2E

F I G. 3

F I G. 4

F I G. 5

FIG. 6A

FIG. 6B

FIG. 6C

F I G. 7A

F I G. 7B

F I G. 7C

F I G. 7D

F I G. 7E

si ION

43

N⁻

51

41

FIG. 8A

50a                    50b

54

53

N⁻                    52

41

FIG. 8B

55

53

N⁻                    52

41

FIG. 8C

si ION

53

N⁻            N⁺            52

N⁺

42b

41

42a

FIG. 8D

FIG. 9

FIG. 10

25a      27a   24   27b        25b    21

N⁺     N⁺   N⁻   N⁺     N⁺

22a        23            22b

F I G. 11

48a   S          G      49       D   48b

45a
49             44            45b
                                             49

N⁺        N⁻     N⁺

43      42b

41

42a

F I G. 12